# EUROPÄISCHE PATENTSCHRIFT

(11) **EP 3 942 239 B1**
(45) Veröffentlichungstag und Bekanntmachung des Hinweises auf die Patenterteilung: **05.03.2025**
(21) Anmeldenummer: 20721222.6
(22) Anmeldetag: 23.04.2020
(51) Int. Cl.: F28F 3/12, F28F 21/08, F28D 1/03, B21D 53/04, F28F 3/14, H01M 10/6556, H05K 7/20, H01M 10/613

(54) **KÜHLVORRICHTUNG ZUM KÜHLEN EINER ENERGIESPEICHER- UND/ODER ELEKTRONIKBAUGRUPPE SOWIE VERFAHREN ZU DEREN HERSTELLUNG**
COOLING DEVICE FOR COOLING AN ENERGY STORE SUBASSEMBLY AND/OR AN ELECTRONICS SUBASSEMBLY, AND METHOD FOR PRODUCING SAME
DISPOSITIF DE REFROIDISSEMENT POUR LE REFROIDISSEMENT D'UN MODULE ÉLECTRONIQUE ET/OU ACCUMULATEUR D'ÉNERGIE AINSI QUE PROCÉDÉ POUR SA FABRICATION

(30) Priorität: 26.04.2019 DE 102019110870
(43) Veröffentlichungstag der Anmeldung: 26.01.2022
(73) Patentinhaber: Liebherr-Electronics and Drives GmbH, 88131 Lindau (DE)
(72) Erfinder: EICHLER, Markus, 79761 Waldshut (DE)
(74) Vertreter: Thoma, Michael
(86) Internationale Anmeldenummer: PCT/EP2020/061322
(87) Internationale Veröffentlichungsnummer: WO 2020/216836

(56) Entgegenhaltungen:
- WO-A2-2011/035943
- DE-A1- 102014 219 812
- DE-C1- 4 432 340
- FR-A1- 2 309 819
- US-A- 2 779 086
- US-A- 3 354 530
- US-A1- 2018 266 738

## Beschreibung

Die vorliegende Erfindung betrifft allgemein das Kühlen von Energiespeicher- und/oder Elektronikbaugruppen. Die Erfindung betrifft dabei einerseits eine Kühlvorrichtung zum Kühlen solcher Energiespeicher und/oder Elektronikbaugruppen mit einem vorzugsweise plattenförmigen Kühlkörper, in dessen Inneren zumindest ein Kühlmittelkanal ausgebildet ist. Die Erfindung betrifft ferner auch die Energiespeicher- und/oder Elektronikbaugruppe mit einer solchen Kühlvorrichtung. Weiterhin betrifft die Erfindung auch ein Verfahren zum Herstellen einer solchen Kühlvorrichtung.

Bei modernen Energiespeichern, die beispielsweise mit Doppelschichtkondensatoren arbeiten können, werden die Leistungsdichte, die Lebensdauer und die Kompaktheit zunehmend durch die mögliche Ableitung der Verlustwärme bestimmt. Durch die hohen Leistungsdichten müssen große Wärmemengen abgeleitet werden, da andernfalls die Energiespeicher zu hohe Temperaturen erlangen, die die Lebensdauer schädigen bzw. verkürzen. Das Ableiten großer Wärmemengen ist dabei jedoch nicht einfach, da die Energiespeicher immer kleiner bauen, sodass nicht mehr genügend Kontaktfläche zu Wärmetauschern bzw. Kühlkörpern zur Verfügung steht. Die genannte Problematik wird nochmals dadurch verschärft, dass die Wärmeübertragung und Zugänglichkeit an Energiespeichern wie beispielsweise Doppelschichtkondensatoren und Batterien wie beispielsweise Lithium-Ionen-Batterien oftmals nur an den Polen der Energiespeicher möglich ist.

Eine ähnliche Problematik hinsichtlich der Wärmeableitung ergibt sich nicht nur bei Energiespeichern, sondern auch bei anderen Elektronikbaugruppen, die bei immer kleiner werdenden Abmessungen hohe Leistungsdichten verarbeiten, wie beispielsweise Drosseln, Schaltanlagen, Stromrichtern oder anderen leistungselektronischen Bauteilen.

Um einerseits eine Isolierung und andererseits gleichzeitig eine gute Wärmeübertragung zu erzielen, werden bisweilen Wärmeleitfolien an den Polen von Energiespeichern bzw. den Anschlusskontakten leistungselektronischer Bauteile angelegt. Die Wärmeübertragung erfolgt somit vom Anschlusspol über die Wärmeleitfolie zum Kühlkörper der Kühlvorrichtung. Der Kühlkörper, der häufig in Form einer Kühlplatte ausgebildet ist, muss aufgrund der Wärmeabfuhr in das Kühlwasser speziell für die Anschlusspole entwickelt und durch recht aufwändige Verfahren hergestellt werden. Beispielsweise werden solche Kühlkörper oft aus zwei Metallplatten hergestellt bzw. aufgebaut, wobei in eine üblicherweise dickere Grundplatte ein Kühlkanalmuster eingefräst wird, welches dann verschlossen wird, indem eine dünnere Deckplatte aufgesetzt und mit der Grundplatte durch Vakuumlöten fluiddicht verbunden wird. Dabei ist nicht nur das Ausfräsen der Kühlkanäle und das Vakuumlöten per se recht aufwändig, sondern es ist vor allen Dingen schwierig, den Kühlkörper so zu konturieren, dass beide Anschlusspole eines Energiespeicher- bzw. Elektronikbausteins an den Kühlkörper angebunden werden können. Da zum Beispiel an einem Doppelschichtkondensator beide Pole gekühlt werden müssen, um die Verlustwärme in ausreichendem Maße abführen zu können, wird der Material- und Fertigungsaufwand sehr hoch und teuer. In ähnlicher Weise sind auch bei Batterien wie beispielsweise LION-Batterien die Pole zu kühlen.

Aus der Schrift DE 10 2014 219 812 A1 ist eine Kühlplatte für einen elektrischen Energiespeicher bekannt, die im Roll-Bonding-Verfahren aus zwei Aluminiumblechen gefertigt wird. Dabei wird vor dem Fügen der Bleche ein Trennmittel in einem Muster entsprechend den gewünschten Kühlkanälen aufgebracht, sodass sich die Bleche im Bereich des Trennmittels nicht fügen und anschließend durch Aufblasen dort aufgewölbt werden können, um die Kühlkanalquerschnitte zu bilden. Ähnliche Kühlvorrichtungen mit gefügten Kühlplatten zeigen auch die Schriften WO 2011/035943 A2, US 2018/266738 A1, FR 2 309 819 A1, DE 44 32 340 C1, US 3 354 530 A und US 2 779 086 A.

Der vorliegenden Erfindung liegt hiervon ausgehend die Aufgabe zugrunde, eine verbesserte Kühlvorrichtung, eine verbesserte Energiespeicher- und/oder Elektronikbaugruppe mit einer solchen Kühlvorrichtung sowie ein verbessertes Verfahren zu deren Herstellung zu schaffen, die Nachteile des Standes der Technik vermeiden und letzteren in vorteilhafter Weise weiterbilden.

Erfindungsgemäß wird die genannte Aufgabe durch eine Kühlvorrichtung nach Anspruch 1, eine Energiespeicher- und/oder Elektronikbaugruppe nach Anspruch 8 sowie ein Verfahren zum Herstellen einer Kühlvorrichtung nach Anspruch 13 gelöst. Bevorzugte Ausgestaltungen der Erfindung sind Gegenstand der abhängigen Ansprüche.

Es wird also vorgeschlagen, den Kühlkörper aus zumindest zwei Blechplatinen aufzubauen, die im Roll-Bonding-Verfahren stoffschlüssig, flächig aufeinander gefügt werden, wobei dem Verlauf des Kühlmittelkanals entsprechende Abschnitte der Blechplatinen vom Fügen ausgespart werden und nach dem Fügen eine Blechplatine im Bereich der ungefügten Abschnitte entsprechend dem Verlauf des Kühlmittelkanals aufgewölbt wird, um den Kühlmittelkanal zu bilden. Die kanalförmige Auswölbung kann sich bei etwa gleichbleibender Wandstärke aus der Fügeebene der beiden Blechplatinen herauswölben, nur randseitig mit der anderen Blechplatine verbunden sein und den Kühlmittelkanal bilden.

Insbesondere kann die genannte Auswölbung im Bereich der ungefügten Abschnitte der Blechplatinen durch Aufblasen ausgebildet werden. Die ungefügten Blechplatinenabschnitte können angestochen und mit Druckluft bzw. einem Druckfluid beaufschlagt werden, das in ungefügte Abschnitte zwischen die beiden Blechplatinen eindringt und diese auseinanderdrückt, sodass sich die genannte Auswölbung bildet.

Um beim Roll-Bonding-Fügeprozess die genannten Abschnitte, in denen sich später die Kühlmittelkanäle ausbilden sollen, vom stoffschlüssigen Zusammenfügen auszusparen, kann vor dem Fügen zumindest eine der beiden Blechplatinen mit einem Trennmittel versehen werden, das entsprechend dem Verlauf des auszubildenden Kühlmittelkanals vorgesehen wird, sodass sie im Bereich des Trennmittels das Fügen der beiden Blechplatinen partiell unterbunden wird.

Das genannte Trennmittel kann beispielsweise ein Trennlack sein, der entsprechend dem Muster bzw. Verlauf des Kühlmittelkanals auf eine oder beide Blechplatinen aufgebracht wird, beispielsweise im Siebdruck. Alternativ oder zusätzlich kann als Trennmittel auch eine reliefartige Einprägung in eines oder beide der Blechplatinen eingebracht werden, beispielsweise in Form einer rinnenförmigen Vertiefung entsprechend dem Kühlmittelkanalverlauf, sodass sich die beiden Blechplatinen im Bereich der eingeprägten Struktur nicht miteinander verbinden.

Als Trennmittel kann beispielsweise Graphit auf eine der Blechplatinen aufgebracht werden.

Vorteilhafterweise sind die den Kühlkörper bildenden Blechplatinen mit Ausnahme der die Kühlmittelkanäle bildenden Aufwölbungen im Wesentlichen vollständig flächig miteinander verbunden, wobei die genannte flächige Verbindung stoffschlüssig ausgebildet sein kann. Die Blechplatinen können mit ihren Flachseiten mit Ausnahme der Kühlmittelkanäle vollständig miteinander stoffschlüssig verbunden sein, sodass die flächige Stoffschlussverbindung nur im Bereich der Kühlmittelkanäle ausgespart ist. Hierdurch kann eine hohe Stabilität bei dünnen Kühlkörperdicken erzielt werden. Insgesamt kann eine sehr geringe Dicke des vorzugsweise plattenförmigen Kühlkörpers erzielt werden, da keine Rücksicht auf notwendige Wandstärken für Schweißprozesse oder kein zusätzliches Auftragen des Lots anfällt.

In vorteilhafter Weiterbildung der Erfindung kann sich die zumindest eine Auswölbung, die den zumindest einen Kühlmittelkanal bildet, im Querschnitt harmonisch gewölbt erstrecken, insbesondere eine harmonisch gekrümmte Wellenform besitzen, die zu den Rändern der Auswölbung hin, also den mit der anderen Blechplatine verbundenen Kanalrändern, sanft ansteigen, sich im Zentrum stärker aufwölben und zum gegenüberliegenden Rand hin wieder sanft abfallen, sodass der Kühlmittelkanal im Querschnitt betrachtet eine harmonisch gekrümmte Konturierung besitzt. Insbesondere kann der Kühlmittelkanal durch Aufblasen ausgebildet werden. Der Kühlmittelkanal wird durch Umformen der Blechplatine insbesondere erst nach dem Fügeprozess ausgebildet, sodass die Blechplatine auch im Bereich der Auswölbung und damit im Bereich des Kühlmittelkanals im Wesentlichen dieselbe Wandstärke behält. Anders als bei Kühlmittelkanälen, die durch Ausfräsen einer Metallplatte gebildet werden, zeigt die Blechplatine im Bereich der Auswölbung keine wesentliche Veränderung in der Wandstärke.

In vorteilhafter Weiterbildung der Erfindung wird der zumindest eine Kühlmittelkanal durch nur eine einseitige Auswölbung gebildet. Während die eine Blechplatine in den ungefügten Abschnitten, die mit einem Trennmittel versehen wurden, ausgewölbt wird und sich aus der Fügeebene herauswölbt, kann die andere Blechplatine eben ausgebildet sein und/oder eine auswölbungsfreie Oberfläche besitzen. Insbesondere kann die genannte andere Blechplatine eine ebene Oberfläche besitzen und/oder eine ebene Platte bilden.

Der Kühlkörper muss dabei allerdings nicht im mathematischen Sinn eine ebene Platte bilden, sondern kann je nach Ausbildung der zu kühlenden Energiespeicher- und/oder Elektronikbaugruppe auch eine gewölbte Platte bilden, wobei die Wölbung einachsig oder zweiachsig sein kann. Beispielsweise kann der Kühlkörper leicht tonnenförmig gewölbt sein, wenn die zu kühlenden Elektronikbauteile beispielsweise mit ihren Anschlusspolen entlang einer leicht schalenförmig gewölbten Kontur angeordnet sind. Insbesondere jedoch kann der Kühlkörper im Wesentlichen eben ausgebildet sein und lediglich die genannten kanalförmigen Auswölbungen zur Bildung der Kühlmittelkanäle als Unregelmäßigkeiten besitzen.

Bei nur einseitiger Auswölbung der Kühlmittelkanäle kann die nicht ausgewölbte Blechplatine im Wesentlichen vollständig eben konturiert sein bzw. bei leicht gewölbter Konturierung eine Hüllfläche besitzen, die der Oberfläche entspricht.

In vorteilhafter Weiterbildung der Erfindung können Blechplatinen gleicher Wandstärke im Roll-Bonding-Prozess miteinander gefügt werden. Unabhängig vom Fügeprozess kann sich die Fügeebene bzw. -fläche zwischen den beiden Blechplatinen im Querschnitt des Kühlkörpers betrachtet etwa mittig in der Querschnittsfläche bzw. durch die Querschnittsfläche erstrecken. Der Kühlköper kann sich von der Fügeebene bzw. -fläche ausgehend zu gegenüberliegenden Seiten hin etwa gleich weit erstrecken.

Gemäß der Erfindung umfasst die Kühlvorrichtung zwei vorzugsweise plattenförmige Kühlkörper, um die Energiespeicher- bzw. Elektronikbaugruppe von gegenüberliegenden Seiten her kühlen zu können. Die beiden Kühlkörper sind dabei durch Zugelemente miteinander verbunden und aneinander gehalten, sodass zwischen den beiden Kühlkörpern ein spaltförmiger Freiraum ausgebildet ist, in welchem die Energiespeicher- bzw. Elektronikbaugruppe angeordnet, insbesondere eingespannt werden kann. Die genannten Zugelemente halten die beiden Kühlkörper in einem Abstand, der im Wesentlichen den Außenabmessungen der Energiespeicher- bzw. Elektronikbaugruppe entspricht, sodass die genannte Baugruppe passgenau zwischen die beiden Kühlkörper eingepasst werden kann.

Alternativ zu zwei separaten Kühlkörpern kann auch ein Kühlkörper Verwendung finden, der eine im Wesentlichen U-förmige Konturierung mit zwei zueinander beabstandeten, insbesondere etwa parallelen Schenkeln besitzt, zwischen denen die zu kühlende Energiespeicher- bzw. Elektronikbaugruppe aufgenommen werden kann. Beispielsweise kann ein plattenförmiger Kühlkörper entlang einer Falz- bzw. Biegelinie bzw. zwei solcher Falz- oder Biegelinien in die U-förmige Konturierung umgeformt werden, sodass der Kühlkörper die Energiespeicher- bzw. Elektronikbaugruppe von drei Seiten her umgreift.

Einfacher in der Ausbildung ist es jedoch, zwei separate Kühlkörper zu verwenden, die von gegenüberliegenden Seiten her auf die zu kühlende Baugruppe gesetzt und durch die genannten Zugelemente gehalten werden.

Die genannten Zugelemente können beispielsweise Zugstangen sein, die unmittelbar oder mittelbar an den genannten Kühlkörpern angreifen können.

Insbesondere kann auf den jeweiligen Kühlkörper eine Halteplatte oder ein Halterahmen aufgesetzt werden, welcher Halterahmen bzw. welche Halteplatte durch die genannten Zugstangen fixiert werden kann. Die genannte Halteplatte bzw. der Halterahmen wird dabei auf die Seite des Kühlkörpers gesetzt, die der zu kühlenden Baugruppe abgewandt ist.

Werden in der zuvor genannten Weise zwei Kühlkörper auf gegenüberliegende Seiten der zu kühlenden Baugruppe gesetzt, können auf die voneinander abgewandten Seiten der Kühlkörper Halteplatten bzw. -rahmen gesetzt werden, welche durch Zugelemente aneinander gehalten und/oder aufeinander zugespannt werden, um die Energiespeicher- bzw. Elektronikbaugruppe zwischen den Kühlkörpern einzuspannen bzw. fixieren.

Vorteilhafterweise können die genannten Zugelemente an den Kühlkörpern und/oder den genannten Halteplatten bzw. -rahmen formschlüssig gehalten, insbesondere verrastbar sein.

In Weiterbildung der Erfindung kann die Energiespeicher- und/oder Elektronikbaugruppe eine Vielzahl von Energiespeicher- und/oder Elektronikbausteinen umfassen, die in einer matrixförmigen Anordnung positioniert sein können.

Vorteilhafterweise werden die genannten mehreren Energiespeicher- und/oder Elektronikbaugruppen durch jeweils einen gemeinsamen Kühlkörper gekühlt, welcher von einer Seite her gegen die Gruppe von Energiespeicher- bzw. Elektronikbausteinen gesetzt wird. Insbesondere können die genannten Energiespeicher- bzw. Elektronikbausteine zwischen zwei plattenförmigen Kühlkörpern angeordnet werden, die die Vielzahl von Energiespeicher- bzw. Elektronikbausteinen sandwichartig zwischen sich aufnehmen.

Die genannten Energiespeicherbausteine können Kondensatoren, insbesondere Doppelschichtkondensatoren umfassen und/oder auf gegenüberliegenden Seiten angeordnete Anschlusspole besitzen, welche Anschlusspole jeweils an einen Kühlkörper der Kühlvorrichtung angeschlossen werden. Die genannten Energiespeicherbausteine können auch Batterien, insbesondere Lithium-Ionen-Batterien bzw. Lithium-Batterien umfassen, deren Anschlusspole jeweils an einen Kühlkörper der Kühlvorrichtung angeschlossen werden.

In vorteilhafter Weiterbildung der Erfindung können die genannten Kühlkörper Kühlanschlussflächen besitzen, die jeweils einen Anschlusspol eines zu kühlenden Energiespeicher- bzw. Elektronikbausteins berühren und an den genannten Anschlusspol formangepasst sind. Besitzen die Anschlusspole beispielsweise eine pilzkopfförmig konturierte Oberfläche können die Kühlkörper entsprechend der pilzkopfförmigen Kontur geformte, schüsselartige Vertiefungen aufweisen. Die formangepassten Anschlussflächen des Kühlkörpers können den Wärmeübergang von den Anschlusspolen in den Kühlkörper verbessern, da die Wärmeübergangsfläche vergrößert wird.

Besitzen die genannten Anschlusspole beispielsweise pinartig vorspringende Anschlusszapfen, können die Kühlkörper auch bohrungs- bzw. lochartige Ausnehmungen umfassen, in welche die Anschlusspolzapfen eingesteckt werden können.

Unabhängig von formangepassten Anschlussflächen kann die Oberfläche des Kühlkörpers mit einer Beschichtung versehen sein, um die Isolation und/oder den Wärmeübergang zu verbessern. Beispielsweise kann eine keramische Beschichtung, insbesondere in Form eines Keramiklacks auf die Kühlkörperoberfläche aufgebracht sein, um die elektrische Isolierung und gleichzeitig die Wärmeübertragung zu verbessern. Alternativ oder zusätzlich zu einer solchen keramischen Beschichtung kann auch eine Plasma-Beschichtung von Oxiden vorgesehen werden. Insbesondere kann eine Beschichtung mit Aluminium-Oxid Al₂O₃ auf die KühlkörperOberfläche aufgebracht werden, um eine hervorragende elektrische Isolation bei gleichzeitig sehr guter Wärmeleitfähigkeit zu erzielen.

Vorteilhafterweise kann eine Verbindung einer Kühlkörperplatte aus Aluminium und dem Oxid sehr einfach und technisch effizient durch Plasma-Auftragung erfolgen, wobei grundsätzlich aber auch andere Auftragsverfahren anwendbar sind. Die Oberfläche ist extrem hart, sehr gleichmäßig eben und mechanisch sehr stabil und somit insbesondere auch für mobile Anwendungen bestens geeignet.

Alternativ oder zusätzlich kann eine vorzugsweise isolierende Wärmeleitfolie auf den Kühlkörper aufgebracht sein, um bei isolierender Wirkung einen guten Wärmeübergang zu erzielen.

Die Erfindung wird nachfolgend anhand eines bevorzugten Ausführungsbeispiels und zugehöriger Zeichnungen näher erläutert. In den Zeichnungen zeigen:
- Fig. 1:: eine Seitenansicht einer Energiespeicherbaugruppe, die sandwichartig zwischen zwei plattenförmigen Kühlkörpern angeordnet ist, welche Kühlkörper durch Zugstangen auf die Energiespeicherbaugruppe gespannt sind,
- Fig. 2:: eine Draufsicht auf eine der plattenförmigen Kühlkörper, wobei der Verlauf des Kühlmittelkanals im Inneren des Kühlkörpers dargestellt ist, und
- Fig. 3:: eine schematische Darstellung der Verfahrensschritte zum Herstellen der plattenförmigen Kühlkörper aus den vorhergehenden Figuren.

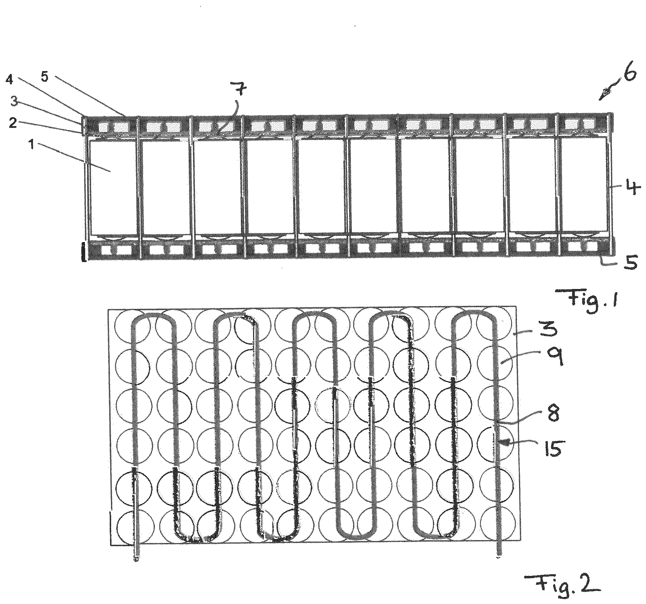

Wie die Figuren 1 und 2 zeigen, kann die Kühlvorrichtung 6 dazu ausgebildet sein, eine Reihe bzw. Matrix von Energiespeichern 1 oder ähnlichen elektronischen, insbesondere leistungselektronischen Bauteilen an ihren Anschlusspolen 7 zu kühlen, wobei es jedoch auch möglich wäre, nur ein einzelnes Energiespeicher- bzw. Elektronikbauteil 1 mittels der Kühlvorrichtung 6 zu kühlen.

Wie die Figuren 1 und 2 zeigen, kann die Kühlvorrichtung 6 zwei plattenförmige Kühlkörper 3 aufweisen, die von gegenüberliegenden Seiten her an die genannte Anordnung von Energiespeichern 1 gesetzt werden, um deren Anschlusspole 7 zu berühren und einen Wärmeübergang von den Anschlusspolen 7 auf die Kühlkörper 3 zu ermöglichen.

Vorteilhafterweise können die Energiespeicher 1 sandwichartig zwischen den beiden plattenförmigen Kühlkörpern 3 angeordnet bzw. eingespannt werden. Die beiden Kühlkörper 3 können mittels Zugelementen 4 beispielsweise in Form von Zugstangen voneinander beabstandet bzw. aneinander gehalten werden, wobei die Zugelemente 4 insbesondere die Kühlkörper 3 an den gegenüberliegenden Seiten der Energiespeicher 1 zusammenhalten können.

Um die Kühlkörper 3 an den Energiespeichern 1 zu halten, können Halter 5, die als Halteplatten oder Halterahmen ausgebildet sein können, auf die von den Energiespeichern 1 abgewandten Seiten der Kühlkörper 3 gesetzt werden, wobei die genannten Halter 5 mittels den Zugelementen 4 zusammengehalten werden, insbesondere derart, dass die Kühlkörper 3 von den Haltern 5 gegen die Stirnseiten bzw. Außenseiten der Energiespeicher 1 gehalten werden.

Die genannten Zugelemente 4 können mit den Haltern 5 vorteilhafterweise formschlüssig verbunden, vorteilhafterweise verrastet werden, wobei aber auch andere Verbindungsmittel wie beispielsweise Schrauben oder Bajonettverschlüsse oder ähnliches vorgesehen sein können.

Die genannten Halter 5 können beispielsweise in Form von preisgünstigen Stahlblechen ausgebildet sein, die auf die Kühlkörper 3 gesetzt werden, wobei jedoch auch anders ausgebildete Halter 5 beispielsweise in Form eines Strebenfachwerks verwendet werden können.

Wie Figur 2 zeigt, können die plattenförmige Kühlkörper 3 in ihrem Inneren einen oder mehrere Kühlmittelkanäle 8 umfassen, wobei beispielsweise ein mäanderförmig sich hin- und herschlängelnder Kühlmittelkanal vorgesehen sein kann, der das Kühlmittel über alle Anschlussflächen bzw. damit in Verbindung stehenden Außenpole 7 der Energiespeicher 1 führt. Anstelle des in Figur 2 gezeigten, mäanderförmigen Kühlmittelkanals 8 können jedoch auch andere Kühlmittelkanal-Muster vorgesehen sein, das mehrere separate und/oder sich verzweigende Kühlmittelkanäle aufweisen kann.

Entsprechend der Anordnung der Energiespeicher 1 und deren Anschlusspole 7 kann der jeweilige Kühlkörper 3 eine entsprechende Anordnung von Kontaktflächen 9 besitzen, die die Energiespeicher 1 an deren Anschlusspolen 7 berühren und an einer Oberfläche, insbesondere einer Flachseite des plattenseitigen Kühlkörpers 3 ausgebildet sein können.

Die beiden genannten Kühlkörper 3 sind dabei vorteilhafterweise jeweils aus zwei Blechplatinen 10, 11 aufgebaut, die voll- bzw. großflächig miteinander stoffschlüssig verbunden werden, um den Kühlkörper 3 zu bilden. Die genannten Blechplatinen 10 und 11 können vorteilhafterweise Aluminiumbleche mit vorzugsweise geringer Wandstärke sein, das heißt die Materialstärke beträgt nur einen Bruchteil der Länge und/oder der Breite der entsprechenden Blechplatine 10 bzw. 11, beispielsweise weniger als 10% oder weniger als 5% der Länge und/oder der Breite.

Gegebenenfalls können auch mehr als 2 Blechplatinen aufeinandergefügt werden, um beispielsweise einen drei- oder mehrschichtigen Kühlkörper 3 auszubilden und/oder einen Kühlkörper 3 mit einem Kühlmittelkanalmuster in unterschiedlichen Schichten zu fertigen.

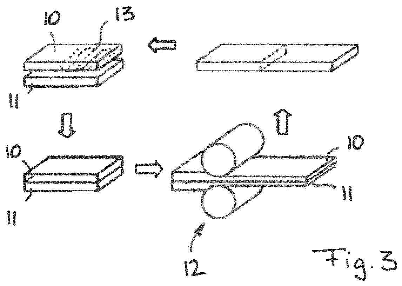

Wie Figur 3 verdeutlicht, können die Blechplatinen 10 und 11 durch einen Roll-Bonding-Prozess miteinander stoffschlüssig gefügt werden, wobei die Blechplatinen 10 und 11 mit ihren großen Flachseiten aufeinander gelegt und durch eine Walzenanordnung 12 hindurchlaufen können. Insbesondere können die aufeinanderliegenden Blechplatinen 10 und 11 durch rotierende Walzen mit hohem Druck und gegebenenfalls auch mit Temperatur beaufschlagt werden, um die Blechplatinen 10 und 11 an den aneinander anliegenden Oberflächen stoffschlüssig zu verbinden. Dabei können die beiden miteinander verbundenen Blechplatinen 10 und 11 gemeinsam eine Materialdicke bzw. Kühlkörperdicke besitzen, die im Vergleich zur Summe der Dicken der Ausgangsblechplatinen reduziert sein kann, vgl. Figur 3.

Wie Figur 3 verdeutlicht, können die beiden Blechplatinen 10 und 11 beispielsweise aus einem Aluminiumblech zugeschnitten werden, um sodann übereinandergelegt zu werden. Um den Roll-Bonding-Fügeprozess zu befördern bzw. zu unterstützen, können die aufeinander zu setzenden Platinenoberflächen bearbeitet, beispielsweise gebürstet oder in anderer Weise vorbereitet werden.

Um in einem späteren Herstellschritt die Ausbildung der Kühlmittelkanäle 8 zu ermöglichen, kann auf zumindest einer Blechplatine 10 ein Trennmittel 13 beispielsweise in Form eines graphithaltigen Lacks entsprechend dem Verlauf des gewünschten Kühlmittelkanals aufgebracht werden, wobei das genannte Trennmittel 13 beispielsweise durch einen Siebdruckprozess aufgebracht werden kann.

Das Trennmittel 13 wird dabei auf die Oberfläche der Blechplatine 10 aufgebracht, die mit der gegenüberliegenden Oberfläche der anderen Blechplatine 11 gefügt werden soll, um Abschnitte der aneinanderliegenden Blechplatinenoberflächen, die dem späteren Muster der gewünschten Kühlmittelkanäle entsprechen, vom Fügeprozess auszusparen. Gegebenenfalls kann das genannte Trennmittel 13 auch auf beiden Blechplatinen 10 und 11 aufgebracht werden, wobei das Trennmittel 13 nicht zwingend auf der Blechplatine aufgebracht werden muss, die später durch Aufblasen ausgewölbt werden soll.

Die solchermaßen vorbereiteten Blechplatinen 10 und 11 werden sodann aufeinandergelegt und sodann durch die Walzenanordnung 10 befördert, durch die sie mit hohem Druck unter gegebenenfalls zusätzlicher Temperaturbeaufschlagung stoffschlüssig miteinander verbunden werden, was insbesondere in einem kontinuierlichem Walzdruck-Prozess unter kontinuierlicher Rotation der Walzen und/oder unter kontinuierlichem Vorschub des Blechplatinenpakets relativ zur Walzenanordnung 12 erfolgen kann.

Durch die Druckbeaufschlagung der Walzen werden die Blechplatinen 10 und 11 flächig miteinander, stoffschlüssig verbunden, und zwar mit Ausnahme der Abschnitte, die mit dem Trennmittel versehen wurden.

Die stoffschlüssig, flächig miteinander verbundenen Blechplatinen 10 und 11 werden sodann in einem folgenden Verfahrensschritt im Bereich der auszubildenden Kühlmittelkanäle 8, das heißt im Bereich des aufgebrachten Trennmittelmusters angestochen, um im Bereich des Trennmittels 13 zwischen den Blechplatinen 10 und 11 Druckluft einblasen zu können, um die Kühlmittelkanäle 8 aufzublasen.

Vorteilhafterweise wird dabei nur eine der Blechplatinen 10 ausgewölbt, während die andere Blechplatine 11 eben gehalten werden kann, beispielsweise durch Auflegen eines ebenen Stempelwerkzeugs, gegen das die verbundenen Blechplatinen durch einen Gegenstempel gedrückt werden können, der im Bereich der auszuformenden Kühlmittelkanäle 8 Aussparungen besitzen kann.

Durch das Aufblasen der angestochenen Trennmittelmuster 13 bilden sich harmonisch gekrümmte Kühlmittelkanäle 8 beispielsweise in Form des mäandernden Kühlmittelkanals 8 aus Figur 2, wobei sich eine der Blechplatinen 10 rinnenförmig auswölbt, wobei die genannte Auswölbung sich aus der Fügeebene herauswölben kann.

Um die elektrische Isolation zu erhöhen und gleichzeitig eine sehr gute Wärmeleitfähigkeit zu erzielen, können die Blechplatinen 10 und 11 und/oder der aufgebaute plattenförmige Kühlkörper 3 mit einer Beschichtung versehen werden, beispielsweise mit einer keramischen Beschichtung beispielsweise in Form eines Keramiklacks oder einer Beschichtung mit Aluminium-Oxid Al₂O₃. Insbesondere kann eine Plasma-Beschichtung einer oder beider Blechplatinen 10 und 11 und/oder des daraus aufgebauten Kühlkörpers 3 mit einem Oxid insbesondere in Form des genannten Aluminium-Oxids Al₂O₃ vorgesehen werden. Hierdurch kann eine sehr harte, gleichmäßig ebene und mechanisch sehr stabile Oberfläche erzielt werden, die gleichzeitig eine hervorragende elektrische Isolation bei gleichzeitig sehr guter Wärmeleitfähigkeit erzielt.

## Patentansprüche

1. Kühlvorrichtung zum Kühlen einer Energiespeicher- und/oder Elektronikbaugruppe (14), mit einem vorzugsweise plattenförmigen Kühlkörper (3), in dessen Inneren zumindest ein Kühlmittelkanal (8) ausgebildet ist, wobei der Kühlkörper (3) zwei stoffschlüssig, flächig aufeinandergefügte Blechplatinen (10, 11) umfasst, wobei eine Blechplatine (10) eine kanalförmige Auswölbung (15) besitzt, die sich bei etwa gleichbleibender Wandstärke aus der Fügeebene der beiden Blechplatinen (10, 11) herauswölbt und den zumindest einen Kühlmittelkanal (8) bildet, **dadurch gekennzeichnet, dass** zwei jeweils vorzugsweise plattenförmige Kühlkörper (3,13), die jeweils zumindest einen Kühlmittelkanal (8) besitzen und zwei aufeinandergefügte Blechplatinen (10, 11) umfassen, voneinander beabstandet angeordnet und durch Zugelemente (4) aneinander gehalten sind und auf der zu kühlenden Energiespeicherbaugruppe (1) gehalten werden können, sodass ein zwischen den Kühlkörpern (3) gebildeter Spalt den Abmessungen der zu kühlenden Energiespeicherbaugruppe (14) entspricht und die genannte Energiespeicherbaugruppe (14) zwischen den Kühlkörpern (3) festgehalten, insbesondere eingespannt werden kann.

2. Kühlvorrichtung nach dem vorhergehenden Anspruch, wobei die flächige, stoffschlüssige Verbindung der beiden Blechplatinen (10, 11) eine Roll-Bonding-Fügeverbindung ist, wobei die genannte Auswölbung (15) im Querschnitt betrachtet eine harmonisch gewölbte Wellenkontur besitzt, wobei die Auswölbung (15) durch Aufblasen gebildet ist.

3. Kühlvorrichtung nach einem der vorhergehenden Ansprüche, wobei nur eine der Blechplatinen (10) eine Aufwölbung (15) besitzt und die andere Blechplatine (11) eben ausgebildet ist und/oder eine auswölbungsfreie Oberfläche besitzt.

4. Kühlvorrichtung nach einem der vorhergehenden Ansprüche, wobei die aufeinandergefügten Blechplatinen (10, 11) mit Ausnahme der genannten Aufwölbungen (15) eine ebene Kühlkörperplatte bilden, wobei die beiden Blechplatinen (10, 11) im Wesentlichen dieselbe Wandstärke besitzen und die Fügeebene oder -fläche zwischen den Blechplatinen (10, 11) etwa mittig durch die Querschnittsfläche des Kühlkörpers (3) geht.

5. Kühlvorrichtung nach einem der vorhergehenden Ansprüche, wobei die Blechplatinen (10, 11) Aluminiumbleche sind und/oder der Kühlkörper (3), insbesondere dessen Blechplatinen (10, 11) mit einer Aluminium-Oxid(Al2O3)-Beschichtung (16) versehen ist.

6. Kühlvorrichtung nach dem vorhergehenden Anspruch, wobei auf den Kühlkörpern (3) auf voneinander abgewandten Oberflächen Halter (5) sitzen, die von den Zugelementen (4) gehalten sind, wobei die Halter (5) plattenförmig ausgebildet und die Zugelemente (4) formschlüssig an den Haltern (5) gehalten, insbesondere einrastbar sind.

7. Kühlvorrichtung nach einem der vorhergehenden Ansprüche, wobei der Kühlkörper (13) an die Anschlusspole des zu kühlenden Energiespeicher-Bausteins formangepasste Anschlussflächen aufweist, insbesondere an pinartig vorspringende Anschlusszapfen einer Batterie und/oder eines Kondensators formangepasste, bohrungs- und/oder lochartige Ausnehmungen als Anschlussflächen aufweist.

8. Energiespeicher- und/oder Elektronikbaugruppe mit einer Kühlvorrichtung (6) zum Kühlen zumindest eines Energiespeicher- und/oder Elektronikbausteins (1), wobei die genannte Kühlvorrichtung (6) gemäß einem der Ansprüche 1 bis 6 ausgebildet ist und der zumindest eine Energiespeicher- und/oder Elektronikbaustein (1) zwischen zwei Kühlkörpern (3) sandwichartig angeordnet, insbesondere eingespannt ist, welche Kühlkörper (3) durch Zugelemente aneinander und an dem zumindest einen Energiespeicher- und/oder Elektronikbaustein (1) gehalten sind.

9. Energiespeicher- und/oder Elektronikbaugruppe nach dem vorhergehenden Anspruch, wobei der zumindest eine/jeder Kühlkörper (3) mit einem Anschlusspol (7) des zu kühlenden Energiespeicher- und/oder Elektronikbausteins in Berührung steht.

10. Energiespeicher- und/oder Elektronikbaugruppe nach einem der vorhergehenden Ansprüche 8-9, wobei zwei von den Kühlkörpern (3) separate Halter (5) vorgesehen sind, die auf den von dem zu kühlenden Energiespeicher- und/oder Elektronikbaustein (1) abgewandten Seiten der Kühlkörper (3) sitzen und durch das zumindest eine Zugelement an dem Energiespeicher und/oder Elektronikbaustein (1) gehalten sind, wobei das zumindest eine Zugelement (4) an zumindest einem der Kühlkörper (3) formschlüssig fixierbar, insbesondere einrastbar ist.

11. Energiespeicher- und/oder Elektronikbaugruppe nach einem der vorhergehenden Ansprüche 8-10, wobei eine Vielzahl von Energiespeicher- und/oder Elektronikbausteinen (1) in einer Reihe oder in einer Matrix benachbart zueinander angeordnet sind und mit zumindest einem gemeinsamen Kühlkörper (3) verbunden sind, insbesondere von zwei gemeinsamen Kühlkörpern (3) auf gegenüberliegenden Seiten eingespannt sind.

12. Energiespeicher- und/oder Elektronikbaugruppe nach einem der vorhergehenden Ansprüche 8-11, wobei der zumindest eine Energiespeicher- und/oder Elektronikbaustein (1) zumindest einen Anschlusspol und der Kühlkörper (3) eine an den genannten Anschlusspol formangepasste Anschlussfläche aufweist, die mit einer isolierenden und/oder wärmeleitenden Beschichtung, insbesondere einer keramischen Beschichtung oder einer Aluminium-OxidBeschichtung versehen ist.

13. Verfahren zum Herstellen einer Kühlvorrichtung (6) zum Kühlen einer Energiespeicher- und/oder Elektronikbaugruppe (14), die zumindest einen vorzugsweise plattenförmigen Kühlkörper (3) mit zumindest einem Kühlmittelkanal (8) umfasst, wobei zur Bildung des Kühlkörpers (3) zwei Blechplatinen (10, 11) durch Roll-Bonding flächig, stoffschlüssig aufeinandergefügt werden, wobei vor dem Fügen auf zumindest einer Blechplatine (10) ein Trennmittel entsprechend dem Verlauf des zumindest einen Kühlmittelkanals (8) vorgesehen wird und nach dem Fügen eine Blechplatine (10) im Bereich des Trennmittels durch Umformen zur Bildung des Kühlmittelkanals (8) aufgewölbt wird, **dadurch gekennzeichnet, dass** auf den zumindest einen Kühlkörper (3) ein vorzugsweise plattenförmiger Halter (5) aufgebracht wird, welcher durch zumindest ein Zugelement (4) gehalten wird.

14. Verfahren nach dem vorhergehenden Anspruch, wobei die Aufwölbung zur Bildung des zumindest einen Kühlmittelkanals (8) durch Aufblasen und/oder Einleiten von Druckfluid in die Fügestelle zwischen den beiden Blechplatinen (10, 11) im Bereich des Trennmittels geformt wird, wobei das Trennmittel (13) vor dem Roll-Bonding-Fügen auf die Oberfläche zumindest einer der Blechplatinen (10) aufgedruckt, insbesondere im Siebdruckprozess aufgedruckt wird.

15. Verfahren nach einem der vorhergehenden Ansprüche 13-14, wobei nur eine der Blechplatinen (10) zur Bildung des zumindest einen Kühlmittelkanals (8) aufgewölbt wird.

16. Verfahren nach einem der vorhergehenden Ansprüche 13-15, wobei auf zumindest eine der Blechplatinen (10, 11) und/oder den Kühlkörper (3) eine isolierende und/oder wärmeleitende Beschichtung, vorzugsweise eine Aluminium-OxidBeschichtung durch Plasma-Auftragung, aufgebracht wird.

## Claims

1. Cooling device for cooling an energy accumulator and/or electronic assembly (14), comprising a preferably plate-shaped heat sink (3) in whose interior at least one coolant channel (8) is formed, wherein the heat sink (3) comprises two sheet metal blanks (10, 11) adhesively joined onto each other surface to surface, wherein one sheet metal blank (10) has a channel-shaped bulge (15) that bulges out of the joining plane of the two sheet metal blanks (10, 11) with about the same wall thickness and forms the at least one coolant channel (8), **characterized in that** in each case two preferably plate-shaped heat sinks (3, 13), which each have at least one coolant channel (8) and comprise two sheet metal blanks (10, 11) joined onto each other are arranged at a distance from each other and are held against each other by traction elements (14) and can be retained on the energy accumulator assembly (1) to be cooled, so that a gap formed between the heat sinks (3) corresponds to the dimensions of the energy accumulator assembly (14) to be cooled, and said energy accumulator assembly (14) can be retained, in particular clamped, between the heat sinks (3).

2. Cooling device according to the preceding claim, wherein the flat, cohesive connection of the two sheet metal blanks (10, 11) is a roll-bonding joining connection, wherein said bulge (15) has a harmoniously curved wave contour as seen in cross-section, wherein the bulge (15) is formed by inflation.

3. Cooling device according to any of the preceding claims, wherein only one of the sheet metal blanks (10) has a bulge (15) and the other sheet metal blank (11) is flat and/or has a bulge-free surface.

4. Cooling device according to any of the preceding claims, wherein the joined sheet metal blanks (10, 11) form a flat heat sink plate with the exception of said bulges (15), wherein the two sheet metal blanks (10, 11) have substantially the same wall thickness and the joining plane or surface between the sheet metal blanks (10, 11) extends approximately centrally through the cross-sectional area of the heat sink (3).

5. Cooling device according to any of the preceding claims, wherein the sheet metal blanks (10, 11) are aluminum sheets and/or the heat sink (3), in particular its sheet metal blanks (10, 11) is provided with an aluminum oxide (Al₂O₃) coating (16).

6. Cooling device according to any of the preceding claims, wherein on surfaces facing apart from each other holders (5) are seated on the heat sinks (3), which are held by the traction elements (4), wherein the holders (5) are of plate-shaped design and the traction elements (4) are positively held on the holders (5), in particular can be latched in place.

7. Cooling device according to any of the preceding claims, wherein the heat sink (13) includes connection surfaces shape-adapted to the connection poles of the energy accumulator module to be cooled, in particular includes bore- and/or hole-like recesses as connection surfaces shape-adapted to pin-like protruding connection journals of a battery and/or capacitor.

8. Energy accumulator and/or electronic assembly comprising a cooling device (6) for cooling at least one energy accumulator and/or electronic module (1), wherein said cooling device (6) is configured according to any of claims 1 to 6 and the at least one energy accumulator and/or electronic module (1) is arranged in a sandwich-like manner, in particular clamped, between two heat sinks (3), which heat sinks (3) are held against each other by traction elements and are held on the at least one energy accumulator and/or electronic module (1).

9. Energy accumulator and/or electronic assembly according to the preceding claim, wherein the at least one/each heat sink (3) is in contact with a connection pole (7) of the energy accumulator and/or electronic module to be cooled.

10. Energy accumulator and/or electronic assembly according to any of the preceding claims 8-9, wherein two holders (5) separate from the heat sinks (3) are provided, which are seated on sides of the heat sinks (3) facing away from the energy accumulator and/or electronic module (1) to be cooled and are held on the energy accumulator and/or electronic module (1) by the at least one traction element, wherein the at least one traction element (4) can be positively fixed, in particular be latched in place on the at least one heat sink (3).

11. Energy accumulator and/or electronic assembly according to any of the preceding claims 8-10, wherein a plurality of energy accumulator and/or electronic modules (1) are arranged adjacent to each other in a row or in a matrix and are connected to at least one common heat sink (3), in particular are clamped by two common heat sinks (3) on opposite sides.

12. Energy accumulator and/or electronic assembly according to any of the preceding claims 8-11, wherein the at least one energy accumulator and/or electronic module (1) includes at least one connection pole, and the heat sink (3) includes a connection surface shape-adapted to said connection pole, which is provided with an insulating and/or thermally conductive coating, in particular a ceramic coating or an aluminum oxide coating.

13. Method of manufacturing a cooling device (6) for cooling an energy accumulator and/or electronic assembly (14) which comprises at least one preferably plate-shaped heat sink (3) with at least one coolant channel (8), wherein for forming the heat sink (3) two sheet metal blanks (10, 11) are cohesively joined onto each other surface to surface by roll bonding, wherein before joining a release agent is provided on at least one sheet metal blank (10) corresponding to the course of the at least one coolant channel (8), and after joining a sheet metal blank (10) is bulged by shaping in the region of the release agent in order to form the coolant channel (8), **characterized in that** on the at least one heat sink (3) a preferably plate-shaped holder (5) is applied, which is held by at least one traction element (4).

14. Method according to the preceding claim, wherein the bulge for forming the at least one coolant channel (8) is formed in the region of the release agent by inflation and/or by introduction of pressurized fluid into the joining point between the two sheet metal blanks (10, 11), wherein before joining by roll bonding, the release agent (13) is printed on the surface of at least one of the sheet metal blanks (10), in particular printed by a screen printing process.

15. Method according to any of the preceding claims 13-14, wherein only one of the sheet metal blanks (10) is bulged for forming the at least one coolant channel (8).

16. Method according to any of the preceding claims 13-15, wherein on at least one of the sheet metal blanks (10, 11) and/or on the heat sink (3) an insulating and/or thermally conductive coating, preferably an aluminum oxide coating is applied by plasma coating.

## Revendications

1. Dispositif de refroidissement pour refroidir un sous-groupe de stockage d'énergie et/ou électronique (14), avec un corps de refroidissement (3) de préférence en forme de plaque, à l'intérieur duquel est réalisé au moins un canal de fluide de refroidissement (8), le corps de refroidissement (3) comprenant deux platines de tôle (10, 11) assemblées à plat l'une sur l'autre par liaison de matière, une platine de tôle (10) possédant un bombement (15) en forme de canal qui, pour une épaisseur de paroi à peu près constante, se bombe hors du plan d'assemblage des deux platines de tôle (10, 11) et forme l'au moins un canal de fluide de refroidissement (8), **caractérisé en ce que** deux corps de refroidissement (3, 13), de préférence en forme de plaque, qui possèdent chacun au moins un canal de fluide de refroidissement (8) et comprennent deux platines de tôle (10, 11) assemblées l'une sur l'autre, sont agencés à distance l'un de l'autre et sont maintenus l'un contre l'autre par des éléments de traction (4) et peuvent être maintenus sur le sous-groupe de stockage d'énergie (1) à refroidir, de telle sorte qu'un espace formé entre les corps de refroidissement (3) correspond aux dimensions du sous-groupe de stockage d'énergie (14) à refroidir et ledit sous-groupe de stockage d'énergie (14) peut être maintenu, notamment serré, entre les corps de refroidissement (3).

2. Dispositif de refroidissement selon la revendication précédente, dans lequel l'assemblage à plat par liaison de matière des deux platines de tôle (10, 11) est une liaison d'assemblage par colaminage, dans lequel ledit bombement (15) possède, vu en coupe transversale, un contour ondulé bombé de manière harmonique, le bombement (15) étant formé par gonflage.

3. Dispositif de refroidissement selon l'une quelconque des revendications précédentes, dans lequel une seule des platines de tôle (10) possède un bombement (15) et l'autre platine de tôle (11) est réalisée plane et/ou possède une surface sans bombement.

4. Dispositif de refroidissement selon l'une quelconque des revendications précédentes, dans lequel les platines de tôle (10, 11) assemblées l'une sur l'autre forment, à l'exception desdits bombements (15), une plaque de corps de refroidissement plane, les deux platines de tôle (10, 11) possédant essentiellement la même épaisseur de paroi, et le plan ou la surface d'assemblage entre les platines de tôle (10, 11) passant approximativement au milieu de la surface de section transversale du corps de refroidissement (3).

5. Dispositif de refroidissement selon l'une quelconque des revendications précédentes, dans lequel les platines de tôle (10, 11) sont des tôles d'aluminium et/ou le corps de refroidissement (3), notamment ses platines de tôle (10, 11), est pourvu d'un revêtement d'oxyde d'aluminium (Al₂O₃) (16).

6. Dispositif de refroidissement selon la revendication précédente, dans lequel des supports (5), qui sont maintenus par les éléments de traction (4), sont placés sur les corps de refroidissement (3) sur des surfaces détournées les unes des autres, les supports (5) étant réalisés en forme de plaque et les éléments de traction (4) étant maintenus par complémentarité de forme sur les supports (5), notamment pouvant être encliquetés.

7. Dispositif de refroidissement selon l'une quelconque des revendications précédentes, dans lequel le corps de refroidissement (13) présente des surfaces de raccordement adaptées à la forme des pôles de raccordement du composant de stockage d'énergie à refroidir, notamment des évidements en forme de trous et/ou de perçages adaptés à la forme de broches de raccordement en saillie de type goupille d'une batterie et/ou d'un condenseur en tant que surfaces de raccordement.

8. Sous-groupe de stockage d'énergie et/ou électronique avec un dispositif de refroidissement (6) pour refroidir au moins un composant de stockage d'énergie et/ou électronique (1), ledit dispositif de refroidissement (6) étant réalisé selon l'une quelconque des revendications 1 à 6 et l'au moins un composant de stockage d'énergie et/ou électronique (1) étant agencé en sandwich, notamment serré, entre deux corps de refroidissement (3), lesquels corps de refroidissement (3) sont maintenus par des éléments de traction l'un contre l'autre et contre l'au moins un composant de stockage d'énergie et/ou électronique (1).

9. Sous-groupe de stockage d'énergie et/ou électronique selon la revendication précédente, dans lequel l'au moins un/chaque corps de refroidissement (3) est en contact avec un pôle de raccordement (7) du composant de stockage d'énergie et/ou électronique à refroidir.

10. Sous-groupe de stockage d'énergie et/ou électronique selon l'une quelconque des revendications 8 à 9 précédentes, dans lequel il est prévu deux supports (5) séparés des corps de refroidissement (3), qui reposent sur les côtés des corps de refroidissement (3) détournés du composant de stockage d'énergie et/ou électronique (1) à refroidir et qui sont maintenus sur le composant de stockage d'énergie et/ou électronique (1) par l'au moins un élément de traction, l'au moins un élément de traction (4) pouvant être fixé par complémentarité de forme sur au moins l'un des corps de refroidissement (3), notamment pouvant être encliqueté.

11. Sous-groupe de stockage d'énergie et/ou électronique selon l'une quelconque des revendications 8 à 10 précédentes, dans lequel une pluralité de composants de stockage d'énergie et/ou électroniques (1) sont agencés les uns à côté des autres en une rangée ou en une matrice et sont reliés à au moins un corps de refroidissement (3) commun, notamment sont serrés par deux corps de refroidissement (3) communs sur des côtés opposés.

12. Sous-groupe de stockage d'énergie et/ou électronique selon l'une quelconque des revendications 8 à 11 précédentes, dans lequel l'au moins un composant de stockage d'énergie et/ou électronique (1) présente au moins un pôle de raccordement et le corps de refroidissement (3) présente une surface de raccordement adaptée à la forme dudit pôle de raccordement, qui est pourvue d'un revêtement isolant et/ou conducteur de chaleur, notamment d'un revêtement céramique ou d'un revêtement d'oxyde d'aluminium.

13. Procédé de fabrication d'un dispositif de refroidissement (6) pour refroidir un sous-groupe de stockage d'énergie et/ou électronique (14), qui comprend au moins un corps de refroidissement (3) de préférence en forme de plaque avec au moins un canal de fluide de refroidissement (8), dans lequel, pour former le corps de refroidissement (3), deux platines en tôle (10, 11) sont assemblées l'une sur l'autre à plat, par liaison de matière, par colaminage, dans lequel, avant l'assemblage, il est prévu sur au moins une platine de tôle (10) un moyen de séparation correspondant au tracé d'au moins un canal de fluide de refroidissement (8) et, après l'assemblage, une platine de tôle (10) est bombée dans la zone du moyen de séparation par déformation pour former le canal de fluide de refroidissement (8), **caractérisé en ce qu'**un support (5) de préférence en forme de plaque est appliqué sur l'au moins un corps de refroidissement (3), lequel est maintenu par au moins un élément de traction (4).

14. Procédé selon la revendication précédente, dans lequel le bombement pour la formation de l'au moins un canal de fluide de refroidissement (8) est formé par gonflage et/ou introduction de fluide sous pression dans la zone d'assemblage entre les deux platines de tôle (10, 11) dans la zone du moyen de séparation, le moyen de séparation (13) étant imprimé, notamment par sérigraphie, sur la surface d'au moins l'une des platines de tôle (10) avant l'assemblage par colaminage.

15. Procédé selon l'une quelconque des revendications 13 à 14 précédentes, dans lequel seule l'une des platines de tôle (10) est bombée pour former l'au moins un canal de fluide de refroidissement (8).

16. Procédé selon l'une quelconque des revendications 13 à 15 précédentes, dans lequel on applique sur au moins l'une des platines de tôle (10, 11) et/ou sur le corps de refroidissement (3) un revêtement isolant et/ou conducteur de chaleur, de préférence un revêtement d'oxyde d'aluminium par application plasma.
